# EUROPEAN PATENT APPLICATION

(11) **EP 4 852 658 A1**
(43) Date of publication of application: **09.12.2026**
(21) Application number: 25189019.0
(22) Date of filing: 11.07.2025
(51) Int. Cl.: H10F 19/75, H10F 10/165

(54) **SOLAR CELL**

(30) Priority: 03.06.2025 CN 202510727263
(71) Applicant: Zhejiang Jinko Solar Co., Ltd., Haining, Zhejiang 314416 (CN)
(72) Inventor: LI, Huimin, Haining, Zhejiang, 314416 (CN); XU, Menglei, Haining, Zhejiang, 314416 (CN); YANG, Jie, Haining, Zhejiang, 314416 (CN); ZHANG, Xinyu, Haining, Zhejiang, 314416 (CN)
(74) Representative: Rösler Rasch van der Heide & Partner

(57) **Abstract**

The present disclosure relates to the technical field of photovoltaic cells and, in particular, to a solar cell, a photovoltaic module and a tandem cell. The solar cell includes a silicon substrate, the silicon substrate includes a first surface and a second surface that are arranged opposite to each other, and first doped layers and second doped layers are arranged at intervals over the first surface. Concave portions are provided in the first doped layers, doped contact portions with polarity different from that of the first doped layers are formed in the concave portions, and the first doped layers are in contact with the doped contact portions. In the present disclosure, the concave portion is provided in the first doped layer, the doped contact portion is provided in the concave portion, and the polarity of the doped contact portion is different from that of the first doped layer, so that the first doped layer and the doped contact portion form a local conduction path, and therefore, a bypass point position is formed at the concave portion, which may reduce a reverse breakdown voltage when a back-contact cell is shielded, thereby improving the hot spot resistance of the solar cell, and alleviating a hot spot phenomenon caused by poor local conduction of the solar cell.

## Description

### TECHNICAL FIELD

The present disclosure relates to the technical field of photovoltaic cells and, in particular, to a solar cell, a photovoltaic module and a tandem cell.

### BACKGROUND

Currently, among solar cells, a back-contact cell is a solar cell in which an emitter and a base contact electrode are both disposed on a back surface (non-light-receiving surface) of the solar cell, and a light-receiving surface of the solar cell is not shielded by any metal electrode, thereby effectively increasing a short-circuit current of the solar cell.

In use of the back-contact cell, when a shielding object in an external environment shields the solar cell, the shielded solar cell may generate a hot spot phenomenon, which may seriously damage the solar cell, and meanwhile, the energy generated by the solar cell that is exposed to light may be consumed by the shielded solar cell.

### SUMMARY

The present disclosure provides a solar cell, a photovoltaic module and a tandem cell, which are intended to alleviate a hot spot phenomenon of the solar cell.

Embodiments of the present disclosure provide a solar cell, including a silicon substrate, the silicon substrate includes a first surface and a second surface that are arranged opposite to each other, and first doped layers and second doped layers are arranged at intervals over the first surface; and concave portions are provided in the first doped layers, doped contact portions with polarity different from that of the first doped layers are formed in the concave portions, and the first doped layers are in contact with the doped contact portions.

In some embodiments of the present disclosure, a spacing region is provided between the first doped layer and the second doped layer adjacent to each other; and a minimum distance between the doped contact portion and the second doped layer is a width of the spacing region.

In some embodiments of the present disclosure, an area ratio of the concave portions to the first doped layers is a, where 0.05 %≤a≤5 %.

In some embodiments of the present disclosure, a one-dimensional size of one of the concave portions is b, where 0.5µm≤b≤240µm.

In some embodiments of the present disclosure, the solar cell further includes a first electrode stacked to and electrically connected to the first doped layer; and along a thickness direction of the solar cell, a projection of each of the doped contact portions on the first surface is not coincident with a projection of the first electrode on the first surface.

In some embodiments of the present disclosure, the doped contact portions are uniformly distributed in the first doped layers.

In some embodiments of the present disclosure, in a direction perpendicular to the thickness direction of the solar cell, the doped contact portions cover at least part of side walls of the concave portions.

In some embodiments of the present disclosure, the concave portions do not penetrate through the first doped layers, and the doped contact portions cover bottom walls of the concave portions.

In some embodiments of the present disclosure, the concave portions penetrate through the first doped layer, and part of the silicon substrate is exposed from the concave portions; and the doped contact portions cover the part of the silicon substrate exposed from the concave portions.

Embodiments of the present disclosure further provide a photovoltaic module, including a first cover plate, a first adhesive film, a solar cell string, a second adhesive film and a second cover plate that are stacked. The solar cell string includes a plurality of solar cells electrically connected to each other, and at least one of the plurality of solar cells is the solar cell described above.

Embodiments of the present disclosure further provide a tandem cell, including a top cell, an intermediate connection layer and a bottom cell; the intermediate connection layer is connected between the top cell and the bottom cell; and the top cell is one of a perovskite cell, a cadmium telluride solar cell, a copper indium gallium selenide solar cell or a gallium arsenide solar cell, and the bottom cell is the solar cell described above.

The embodiments of the present disclosure have the following technical effects: the first doped layer is provided with the concave portion, the doped contact portion is arranged in the concave portion, and the polarity of the doped contact portion is different from that of the first doped layer, so that the first doped layer and the doped contact portion form a local conduction path, and therefore, a bypass point position is formed at the concave portion, which may reduce the reverse breakdown voltage when a back-contact cell is shielded, thereby improving the hot spot resistance of the solar cell, and improving a hot spot phenomenon caused by poor local conduction of the solar cell.

It is to be understood that both the foregoing general description and the following detailed description are exemplary only and are not intended to limit the present disclosure.

### BRIEF DESCRIPTION OF DRAWINGS

FIG. 1 is a schematic structural diagram of a photovoltaic module according to the present disclosure;
FIG. 2 is a schematic sectional diagram of a solar cell according to the present disclosure;
FIG. 3 is a schematic distribution diagram of a first doped layer and a second doped layer in the present disclosure;
FIG. 4 is a schematic distribution diagram of doped contact portions on a first doped layer in the present disclosure;
FIG. 5 is a schematic distribution diagram of doped contact portions on a first doped layer in one or more embodiments of the present disclosure;
FIG. 6 is a schematic sectional diagram of a partial structure of a solar cell according to the present disclosure;
FIG. 7 is a schematic sectional diagram of a partial structure of a solar cell according to one or more embodiments of the present disclosure;
FIG. 8 is a schematic sectional diagram of a partial structure of a solar cell according to one or more embodiments of the present disclosure;
FIG. 9 is a schematic sectional diagram of a partial structure of a solar cell according to one or more embodiments of the present disclosure; and
FIG. 10 is a schematic sectional diagram of a partial structure of a solar cell according to one or more embodiments of the present disclosure.

### Reference signs:

10-photovoltaic module;
   101-first cover plate;
   102-first adhesive film;
   103-solar cell string;
   104-second adhesive film;
   105-second cover plate;
1-solar cell;
   11-silicon substrate;
   11a-first surface;
   11b-second surface;
   111-first doped layer;
      111a-concave portion;
      111b-doped contact portion;
   112-second doped layer;
   113-spacing region;
   114-first electrode;
   115-second electrode;
   116-tunnel oxide layer;
   117-back passivation layer;
   118-front passivation layer.

The accompanying drawings, which are incorporated in and constitute a part of this specification, illustrate embodiments consistent with the disclosure and, together with the description, serve to explain the principles of the disclosure.

### DESCRIPTION OF EMBODIMENTS

In order to better illustrate the technical solution of the present disclosure, embodiments of the present disclosure are described in detail below with reference to the accompanying drawings.

It should be clear that the described embodiments are merely some but not all of the embodiments of the present disclosure. All other embodiments obtained by a person of ordinary skill in the art based on the embodiments of the present disclosure without creative efforts shall fall within the protection scope of the present disclosure.

The terminology used in embodiments of the present disclosure is for the purpose of describing particular embodiments only and is not intended to limit the present disclosure. As used in embodiments of the present disclosure and the appended claims, "a" and "the" in singular forms mean including plural forms, unless clearly indicated in the context otherwise.

It should be understood that the term "and/or" as used herein is merely an association relationship describing associated objects, indicating that three relationships may exist. For example, A and/or B indicates that there are three cases of A alone, A and B together, and B alone. In addition, the character "/" herein generally means that associated objects before and after "/"are in an "or" relationship.

It should be noted that the directional terms "upper", "lower", "left", "right", etc. described in embodiments of the present disclosure are used at the orientation shown in the drawings, and should not be construed as limiting the embodiments of the present disclosure. Furthermore, in the context, it should also be understood that when an element is referred to as being connected "on" or "below" another element, it can be directly connected "on" or "below" the other element or be indirectly connected "on" or "below" the other element via intervening elements.

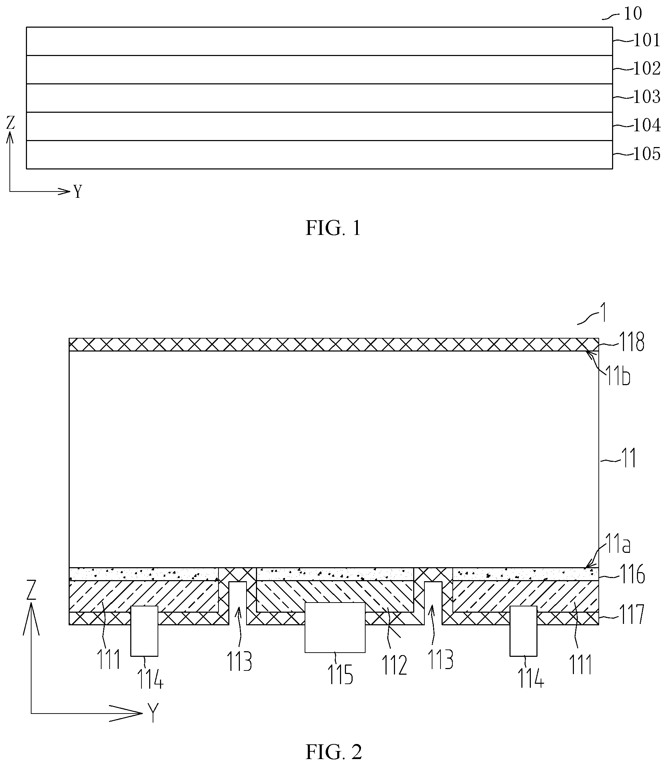

In the technical field of photovoltaic power generation, a photovoltaic module is a core element for converting solar energy into electric energy. FIG. 1 is a schematic structural diagram of a photovoltaic module 10. The photovoltaic module 10 includes a first cover plate 101, a first adhesive film 102, a solar cell string 103, a second adhesive film 104 and a second cover plate 105 that are stacked in a thickness direction Z of the photovoltaic module 10. The first cover plate 101 and the solar cell string 103 are packaged and fixed by the first adhesive film 102, and the second cover plate 105 and the solar cell string 103 are packaged and fixed by the second adhesive film 104.

In some embodiments, the first cover plate 101 and/or the second cover plate 105 may be photovoltaic glass having a relatively high light transmittance, such as dual-coated glass, and the first cover plate 101 and the second cover plate 105 serve to protect an internal packaging material and the solar cell string 103 from mechanical damage and external environment erosion and have a waterproof and moisture-proof capability. In a lamination process of the photovoltaic module 10, the first adhesive film 102 and the second adhesive film 104 are configured to package the solar cell string 103, so as to prevent the external environment from affecting the performance of the solar cell string 103, and meanwhile can bond the first cover plate 101, the solar cell string 103 and the second cover plate 105 into a whole.

One or more solar cell strings 103 may be provided, and when there are a plurality of solar cell strings 103, the plurality of solar cell strings 103 may be connected in series, in parallel, or in series-parallel. The series-parallel connection means that the connection of the plurality of solar cell strings 103 includes series connection and parallel connection, which can provide a higher voltage and capacity. An end of a busbar is connected to the solar cell string 103, and another end of the busbar is connected to a junction box, so that electric energy generated by the photovoltaic module 10 can be led out through the junction box into an external load.

The first adhesive film 102 and the second adhesive film 104 may be formed by one of an ethylene-vinyl acetate copolymer (EVA), a polyolefin elastomer (POE), polyvinyl butyral (PVB), or the like, or may be EPE adhesive film (EVA-POE-EVA co-extrusion structure) or EP adhesive films (EVA-EP co-extrusion structure).

It can be understood that other layer may be provided between the first cover plate 101 and the first adhesive film 102, between the first adhesive film 102 and the solar cell string 103, between the solar cell string 103 and the second adhesive film 104, and between the second adhesive film 104 and the second cover plate 105, and a specific number of layers of the photovoltaic module 10 may be set according to actual situations, no limitation is made herein.

In some embodiments, in the photovoltaic module 10, the single solar cells 1 are connected in series and parallel, and packaged, and connected to external connection wires, so that the photovoltaic module becomes a solar cell 1 module that can be used independently as a photovoltaic power source. The photovoltaic module 10 utilizes a photovoltaic effect to convert solar radiant energy directly to be the expected electrical energy output by absorbing sunlight.

FIG. 2 is a schematic sectional diagram of a solar cell 1. The solar cell 1 includes a silicon substrate 11, and the silicon substrate 11 includes a first surface 11a and a second surface 11b arranged opposite to each other along the thickness direction Z of the solar cell 1.

In some embodiments, a material of the silicon substrate 11 may be an elemental semiconductor material. In some embodiments, the elemental semiconductor material is composed of a single element which may be, for example, silicon. The elemental semiconductor material may be in a single crystal state, a polycrystalline state, an amorphous state, or a microcrystalline state (a state having both a single crystal state and an amorphous state), and for example, the silicon may be at least one of single crystal silicon, polycrystalline silicon, amorphous silicon, and microcrystalline silicon.

In some embodiments, the silicon substrate 11 may be an N-type semiconductor substrate or a P-type semiconductor substrate. The N-type semiconductor substrate is doped with an N-type element, and the N-type element can be any one of V-group elements, such as phosphorus (P), bismuth (Bi), antimony (Sb), or arsenic (As). The P-type semiconductor substrate is doped with a P-type element, and the P-type doped element may be any one of III-group elements, such as boron (B), aluminum (Al), gallium (Ga), or indium (In).

In some embodiments, the first surface 11a of the silicon substrate 11 may be a back surface, and the second surface 11b of the silicon substrate 11 may be a front surface. When the solar cell 1 is a single-sided cell, the second surface 11b may be a light-receiving surface for receiving incident light, and the first surface 11a may be a backlight surface. When the solar cell 1 is a double-sided cell, the first surface 11a and the second surface 11b of the silicon substrate 11 can be light-receiving surfaces, and can be configured to receive the incident light. The first surface 11a may also receive the incident light, but the efficiency of receiving the incident light is lower than that of the second surface 11b.

The second surface 11b has a textured structure, and the textured structure is a regular pyramid textured structure. An inclined surface of the textured structure can increase internal reflection of the incident light, thereby increasing an absorption utilization rate of the incident light by the silicon substrate 11, thus improving the cell efficiency of the solar cell 1.

With continued reference to FIG. 2, a tunnel oxide layer 116 is provided at a side of the first surface 11a away from the silicon substrate 11; first doped layers 111 and second doped layers 112 arranged at intervals are provided at a side of the tunnel oxide layer 116 away from the silicon substrate 11, while a spacing region 113 being arranged between the first doped layer 111 and the second doped layer 112; and a back passivation layer 117 is provided at a side of the first doped layer 111 away from the silicon substrate 11, at a side of the second doped layer 112 away from the silicon substrate 11, and at the spacing region 113. The first surface 11a is further provided with a first electrode 114 and a second electrode 115, a partial structure of the first electrode 114 penetrates through the back passivation layer 117 to be electrically connected to the first doped layer 111, and a partial structure of the second electrode 115 penetrates through the back passivation layer 117 to be electrically connected to the second doped layer 112.

The first electrode 114 and the second electrode 115 are fingers of the solar cell 1 and configured to collect and summarize the current of the solar cell 1, and the first electrode 114 and the second electrode 115 may be formed by sintering a burn-through paste.

In some embodiments, the first electrode 114 and the second electrode 115 may be formed by: printing a metal paste on a surface of the back passivation layer 117 using a screen printing process, and performing a sintering process on the metal paste, the metal paste containing glass powder or a material having a highly corrosive component, so that the corrosive component corrodes the back passivation layer 117 during the sintering process, thereby allowing the metal paste to penetrate into the back passivation layer 117 and be electrically contact the first doped layer 111 or the second doped layer 112.

The metal paste may include at least one of silver, aluminum, copper, tin, gold, lead, and nickel.

With continued reference to FIG. 2, a front passivation layer 118 is provided at a side of the second surface 11b away from the silicon substrate 11.

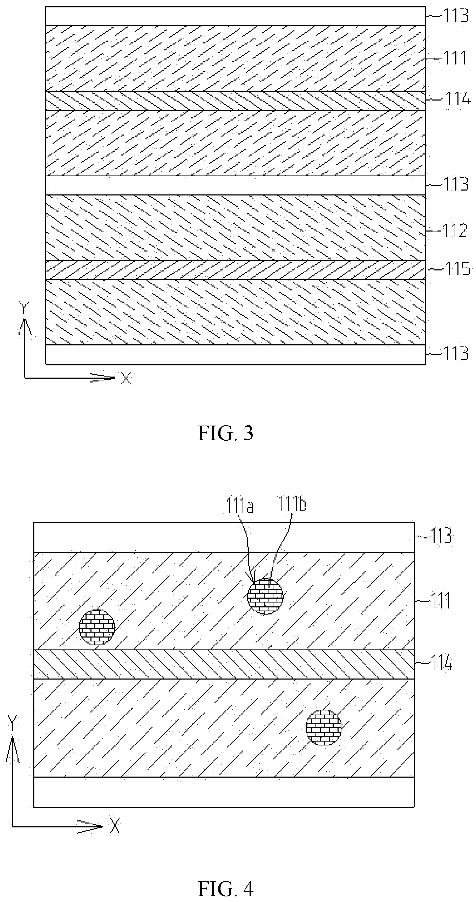

FIG. 3 is a schematic distribution diagram of a first doped layer 111 and a second doped layer 112, and a spacing region 113 is arranged between the first doped layer 111 and the second doped layer 112, to realize automatic isolation between regions with different conductivity types, so as to avoid that a heavily doped P region and N region on a back surface of the solar cell 1 form a tunnel junction to generate electric leakage to influence the efficiency of the solar cell. The first doped layer 111 is electrically connected to the first electrode 114, and the second doped layer 112 is electrically connected to the second electrode 115.

It may be understood that the first doped layer 111 may be an N-type doped layer and the second doped layer 112 may be a P-type doped layer. Alternatively, the first doped layer 111 may be a P-type doped layer, and the second doped layer 112 may be an N-type doped layer. The design may be set according to actual situations as long as the polarity of the first doped layer 111 is different from that of the second doped layer 112, no limitation is made herein.

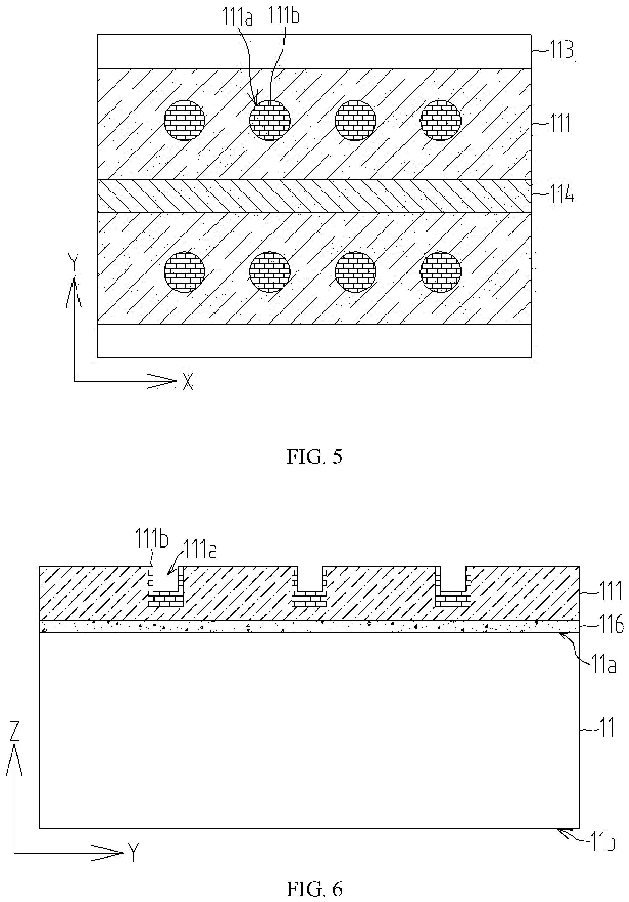

FIG. 4 is a schematic distribution diagram of a doped contact portion 111b on a first doped layer 111 according to one or more embodiments, and FIG. 5 is a schematic distribution diagram of a doped contact portion 111b on a first doped layer 111 according to one or more embodiments. With reference to FIG. 4 and FIG. 5, a concave portion 111a is provided in the first doped layer 111, and a doped contact portion 111b with polarity different from that of the first doped layer 111 is formed in the concave portion 111a. The first doped layer 111 contacts the doped contact portion 111b.

The concave portion 111a may be a groove structure formed in the first doped layer 111. That is, the concave portion 111a does not completely penetrate through the first doped layer 111 along the thickness direction Z of the solar cell 1. Alternatively, the concave portion 111a may be a hole structure formed in the first doped layer 111. That is, the concave portion 111a completely penetrates through the first doped layer 111 along the thickness direction Z of the solar cell 1. The design may be set according to actual situations, no limitation is made herein.

In some embodiments, the first doped layer 111 is provided with the concave portion 111a, the doped contact portion 111b is arranged in the concave portion 111a, and the polarity of the doped contact portion 111b is different from that of the first doped layer 111, so that the first doped layer 111 contacts the doped contact portion 111b to form a local conduction path, and therefore, a bypass point position is formed at the concave portion 111a, which may reduce a reverse breakdown voltage when the solar cell 1 is shielded, thereby improving the hot spot resistance of the solar cell, and alleviating a hot spot phenomenon caused by poor local conduction of the solar cell 1.

It should be noted that an orthogonal projection of the concave portion 111a on the first surface 11a may have a circular shape, a polygonal shape, or an irregular shape. The design may be set according to actual situations, no limitation is made herein.

With reference to FIG. 3, FIG. 4 and FIG. 5, a spacing region 113 is arranged between the first doped layer 111 and the second doped layer 112, and a minimum distance between the doped contact portion 111b and the second doped layer 112 is a width of the spacing region 113. That is, although the doped contact portion 111b has polarity different from that of the first doped layer 111, there is no contact between the doped contact portion 111b and the second doped layer 112, that is, the doped contact portion 111b is not an extension structure of the second doped layer 112 that extends to the first doped layer 111.

With reference to FIG. 4 and FIG. 5, along the thickness direction Z of the solar cell 1, a projection of the doped contact portion 111b on the first surface 11a is not coincident with a projection of the first electrode 114 on the first surface 11a. That is, the doped contact portion 111b does not overlap with the first electrode 114, and the doped contact portion 111b in the first doped layer 111 does not contact the first electrode 114, so that no additional metal recombination loss is introduced.

With continued reference to FIG. 5, in some embodiments, the doped contact portions 111b are uniformly distributed in the first doped layer 111. That is, the doped contact portions 111b are arranged in an array in the first doped layer 111. Due to the array arrangement of the doped contact portions 111b, corresponding local conduction path structures exist at positions of the first doped layer 111 of the solar cell 1, so as to alleviate the hot spot phenomenon of the solar cell 1.

In some embodiments, the concave portions 111a may form approximately uniform distribution by patterning means, such as a mask process, an ink process and a laser process, so that local conduction may be realized, and hot spot reduction may be more controllable. Moreover, the concave portion 111a may be arranged in a manner of completely avoiding the region of the first electrode 114, thereby avoiding the metal recombination loss.

Taking the laser process as an example, the first doped layer 111 and the second doped layer 112 may be formed by: first forming the first doped layer 111 at a side of the tunnel oxide layer 116 away from the silicon substrate 11, then removing a part of the first doped layer 111 in a local laser manner, then forming the second doped layer 112 in the region where the first doped layer 111 is removed, and then performing etching and acid cleaning, so as to form the spacing region 113 between the first doped layer 111 and the second doped layer 112.

Based on the formation manner of the first doped layer 111 and the second doped layer 112, the concave portion 111a may be formed by: forming the first doped layer 111 at a side of the tunnel oxide layer 116 away from the silicon substrate 11, removing a part of the first doped layer 111 in a local laser manner, and then forming the concave portion 111a in the first doped layer 111 in a laser manner.

Alternatively, the concave portion 111a may be formed by: forming the first doped layer 111 at a side of the tunnel oxide layer 116 away from the silicon substrate 11, removing a part of the first doped layer 111 in a local laser manner, and meanwhile forming the concave portion 111a in the first doped layer 111. The formation manner may be set according to design situations, no limitation is made herein.

It may be understood that reference may be made to the above description for the method for forming the concave portion by using the ink process and the mask process, which is not repeated herein.

Based on the formation manner of the first doped layer 111 and the second doped layer 112, the doped contact portion 111b may be formed by: forming the doped contact portion 111b in the concave portion 111a while forming the second doped layer 112 in the region where the first doped layer 111 is removed. That is, the doped contact portion 111b and the second doped layer 112 are formed by the same material, so that the polarity of the doped contact portion 111b is different from that of the first doped layer 111.

With continued reference to FIG. 4, it may be understood that in some embodiments, the doped contact portions 111b may be non-uniformly distributed in the first doped layer 111.

It may be understood that some concave portions 111a may be randomly formed during the process of forming the solar cell 1. For example, the concave portions 111a may be formed in the first doped layer 111 during a high temperature process, a subsequent wet process, or the like.

It should be noted that, even though some concave portions 111a may be randomly formed in the process of forming the solar cell 1, after the doped contact portions 111b are formed in the concave portions 111a, the local conduction paths formed by the doped contact portions 111b and the first doped layer 111 cannot meet the hot spot reduction requirement. Therefore, according to the embodiments of the present disclosure, the concave portion 111a is continuously formed in the first doped layer 111, and the doped contact portion 111b is formed in the concave portion 111a, so as to further reduce the hot spot phenomenon.

In some embodiments, an area ratio of the concave portion 111a to the first doped layer 111 is a, where 0.05 %≤a≤5 %. That is, a ratio of an area of the orthographic projection of the concave portion 111a on the first doped layer 111 to an area of the first doped layer 111 is within a range from 0.05% to 5%.

For example, the ratio of the area of the orthographic projection of the concave portion 111a on the first doped layer 111 to the area of the first doped layer 111 may be 0.05%, 0.1%, 0.25%, 0.5%, 0.75%, 1%, 1.25%, 1.5%, 1.75%, 2%, 2.25%, 2.5%, 2.75%, 3%, 3.25%, 3.5%, 3.75%, 4%, 4.25%, 4.5%, 4.75%, 5%, or the like, which may be set according to practical situations, no limitation is made herein.

In some embodiments, the larger the ratio of the area of the orthographic projection of the concave portion 111a on the first doped layer 111 to the area of the first doped layer 111 is, the larger the contact surface between the doped contact portion 111b in the concave portion 111a and the first doped layer 111 is, and the better the local conduction effect is. The smaller the ratio of the area of the orthographic projection of the concave portion 111a on the first doped layer 111 to the area of the first doped layer 111 is, the smaller the contact surface between the doped contact portion 111b in the concave portion 111a and the first doped layer 111 is, and the lower the capability of the doped contact portion 111b to affect the efficiency of the solar cell 1. Therefore, by setting the area ratio of the concave portion 111a to the first doped layer 111 to be within a range from 0.05% to 5%, the local conduction effect of the solar cell 1 can be improved, and meanwhile, an influence on the photoelectric conversion efficiency of the solar cell 1 can be avoided.

Further, the ratio of the area of the orthographic projection of the concave portion 111a on the first doped layer 111 to the area of the first doped layer 111 is within a range from 0.3% to 1.5%.

For example, the ratio of the area of the orthographic projection of the concave portion 111a on the first doped layer 111 to the area of the first doped layer 111 may be 0.3%, 0.4%, 0.5%, 0.6%, 0.7%, 0.8%, 0.9%, 1.0%, 1.1%, 1.2%, 1.3%, 1.4%, 1.5%, or the like, or the ratio may be enlarged or reduced according to practical situations, may be set according to practical situations, no limitation is made herein.

In some embodiments, a one-dimensional size of the concave portion 111a is b, where 0.5µm≤b≤240µm.

For example, the one-dimensional size of the concave portion 111a may be 0.5µm, 20µm, 40µm, 60µm, 80µm, 100µm, 120µm, 140µm, 160µm, 180µm, 200µm, 220µm, 240µm, or the like, may be set according to practical situations, no limitation is made herein.

In some embodiments, the larger the one-dimensional size of the concave portion 111a is, the larger the contact surface between the doped contact portion 111b in the concave portion 111a and the first doped layer 111 is, and the better the local conduction effect is. The smaller the one-dimensional size of the concave portion 111a is, the smaller the contact surface between the doped contact portion 111b in the concave portion 111a and the first doped layer 111 is, and the lower the capability of the doped contact portion 111b to affect the efficiency of the solar cell 1. Therefore, by setting the one-dimensional size of the concave portion 111a to be within a range from 0.5µm to 240µm, the local conduction efficiency of the solar cell 1 can be improved, and meanwhile, the influence on the photoelectric conversion efficiency of the solar cell 1 can be avoided.

The projection of the concave portion 111a on the first doped layer 111 may be circular, rectangular, elliptical or triangular. The one-dimensional size of the concave portion 111a may be a diameter of a circle, a side length of a rectangle or triangle, a side length of an ellipse, or the like, and the one-dimensional size of the concave portion 111a may also be a line connecting two angles, or the like.

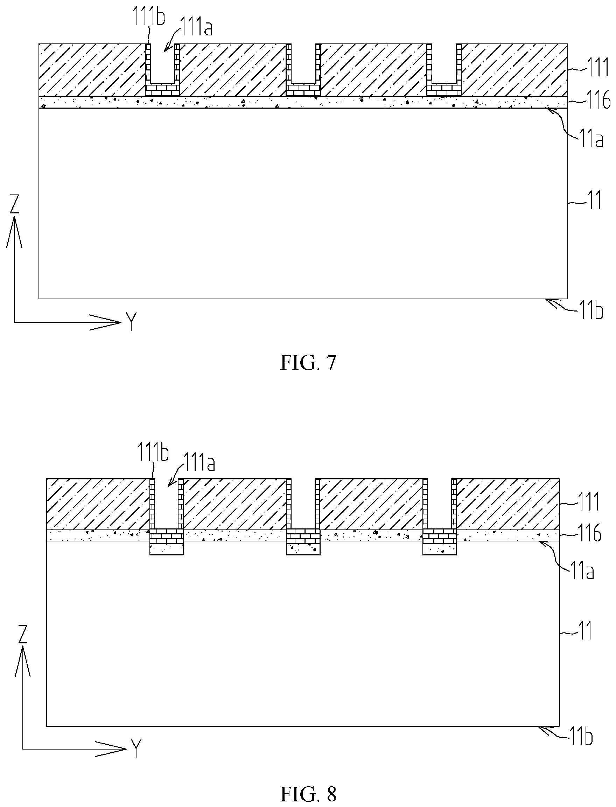

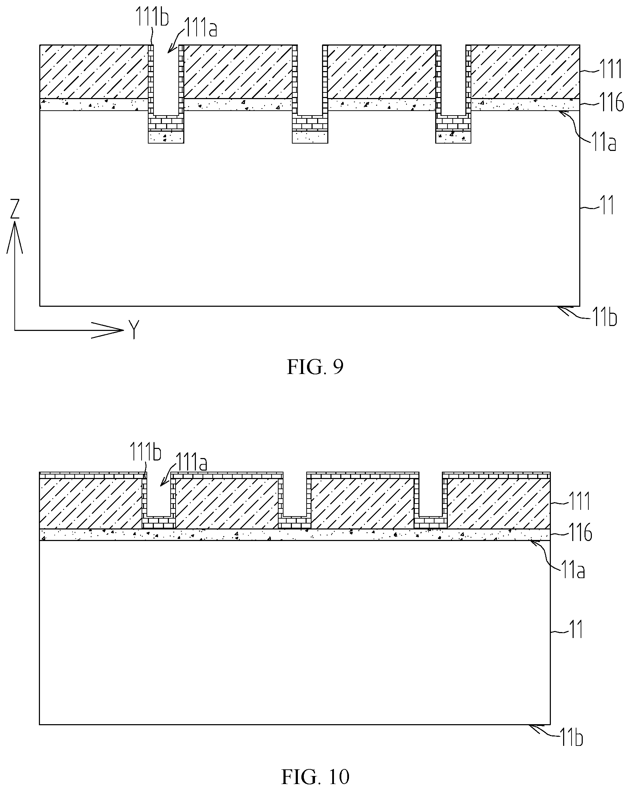

FIG. 6 is a schematic diagram illustrated a doped contact portion 111b being formed in the concave portion 111a of the first doped layer 111 in one or more embodiments, FIG. 7 is a schematic diagram illustrating a doped contact portion 111b being formed in the concave portion 111a of the first doped layer 111 in one or more embodiments, FIG. 8 is a schematic diagram illustrating a doped contact portion 111b being formed in the concave portion 111a of the first doped layer 111 in one or more embodiments, FIG. 9 is a schematic diagram illustrating a doped contact portion 111b being formed in the concave portion 111a of the first doped layer 111 in one or more embodiments, and with reference to FIG. 6, FIG. 7, FIG. 8 and FIG. 9, the doped contact portion 111b covers at least a partial region of a side wall of the concave portion 111a along a direction perpendicular to the thickness direction Z of the solar cell 1.

The doped contact portion 111b may completely cover all of the side wall surfaces and a bottom wall surface of the concave portion 111a. Alternatively, the doped contact portion 111b may cover part of the side wall surfaces and not cover the bottom wall surface. Alternatively, the doped contact portion 111b may cover part of the side wall surfaces and cover the entire bottom wall surface. Alternatively, the doped contact portion 111b may cover part of the side wall surfaces and part of the bottom wall surface. Alternatively, the doped contact portion 111b may cover all of the side wall surfaces but not cover the bottom wall surface. The design may be set according to actual situations, no limitation is made herein.

It may be understood that when the first doped layer 111 is provided with the concave portion 111a, the concave portion 111a may not penetrate through the first doped layer 111, or may completely penetrate through the first doped layer 111, and the design may be set according to actual situations, no limitation is made herein.

In some embodiments, with reference to FIG. 6, the concave portion 111a does not penetrate through the first doped layer 111, and the doped contact portion 111b covers a bottom wall of the concave portion 111a. That is, the concave portion 111a does not completely penetrate through the first doped layer 111 in the thickness direction Z of the first doped layer 111, and the doped contact portion 111b covers at least part of the side wall surface of the concave portion 111a and at least part of the bottom wall surface of the concave portion 111a.

In some embodiments, the concave portion 111a is a groove structure that does not completely penetrate through the first doped layer 111, and the doped contact portion 111b can form a local conduction path together with the first doped layer 111 on the side wall surface and the bottom wall surface of the concave portion 111a.

Alternatively, with reference to FIG. 7, the concave portion 111a penetrates through the first doped layer 111, a part of the back passivation layer 117 is exposed from the concave portion 111a, and the doped contact portion 111b covers the back passivation layer 117 exposed from the concave portion 111a. That is, the concave portion 111a completely penetrates through the first doped layer 111 in the thickness direction Z of the first doped layer 111, and the doped contact portion 111b covers at least part of the side wall surface of the concave portion 111a and a part of the back passivation layer 117.

In some embodiments, the concave portion 111a is a hole structure that completely penetrates through the first doped layer 111, and the doped contact portion 111b can form a local conduction path together with the first doped layer 111 on the side wall surface of the concave portion 111a.

Alternatively, with reference to FIG. 8, the concave portion 111a penetrates through the first doped layer 111 and the back passivation layer 117, a part of the silicon substrate 11 is exposed from the concave portion 111a, and the doped contact portion 111b covers the silicon substrate 11 exposed from the concave portion 111a. That is, the concave portion 111a completely penetrates through the first doped layer 111 and the back passivation layer 117 in the thickness direction Z of the first doped layer 111, and the doped contact portion 111b covers at least part of the side wall surface of the concave portion 111a and a part of the silicon substrate 11.

In some embodiments, the concave portion 111a is a hole structure that completely penetrates through the first doped layer 111, and the doped contact portion 111b can form a local conduction path together with the first doped layer 111 on the side wall surface of the concave portion 111a.

Alternatively, with reference to FIG. 9, the concave portion 111a penetrates through the first doped layer 111, the back passivation layer 117 and a part of the silicon substrate 11, a part of the silicon substrate 11 is exposed from the concave portion 111a, and the doped contact portion 111b covers the silicon substrate 11 exposed from the concave portion 111a. That is, the concave portion 111a penetrates through the first doped layer 111, the back passivation layer 117 and a part of the silicon substrate 11 in the thickness direction Z of the first doped layer 111, and the doped contact portion 111b covers at least a part of the side wall surface of the concave portion 111a and a part of the silicon substrate 11.

In some embodiments, the concave portion 111a is a hole structure that completely penetrates through the first doped layer 111, and the doped contact portion 111b can form a local conduction path together with the first doped layer 111 on the side wall surface of the concave portion 111a.

FIG. 10 is a schematic diagram illustrating a doped contact portion 111b being formed in the concave portion 111a of the first doped layer 111 in one or more embodiments, a silicon oxide layer is formed on a surface of the first doped layer 111, the second doped layer 112 is formed in the region where the first doped layer 111 is removed, and when the doped contact portion 111b is formed in the concave portion 111a, the treatment may be performed on the entire first surface 11a. That is, the second doped layer 112 can be formed on the first doped layer 111, and the silicon oxide layer on the surface of the first doped layer 111 can isolate the first doped layer 111 from the second doped layer 112, so as to prevent the first doped layer 111 from directly contacting the second doped layer 112, thereby simplifying the forming process.

Embodiments further provide a tandem cell, including a top cell, an intermediate connection layer and a bottom cell. The intermediate connection layer is connected between the bottom cell and the top cell. The top cell is one of a perovskite cell, a cadmium telluride solar cell 1, a copper indium gallium selenide solar cell 1 and a gallium arsenide solar cell 1; and the bottom cell is the above-described solar cell 1.

The intermediate connection layer is generally formed by a transparent material with a high refractive index. An effective intermediate connection layer needs to have high optical transparency to reduce reflection and absorption of light at a connection layer interface, and good electrical conductivity to reduce an influence of series resistance on a device performance. For example, a transparent conductive metal oxide thin film (ITO) may be used as the intermediate connection layer.

The above description merely illustrates some preferred embodiments of the present disclosure and is not intended to limit the present disclosure, and various modifications and changes may be made to the present disclosure by those skilled in the art. Any modification, equivalent replacement, or improvement made within a spirit and a principle of the present disclosure shall fall within a scope of the present disclosure.

## Claims

1. A solar cell (1), comprising a silicon substrate (11), wherein
the silicon substrate (11) comprises a first surface (11a) and a second surface (11b) that are arranged opposite to each other, and first doped layers (111) and second doped layers (112) are arranged at intervals over the first surface (11a); and
concave portions (111a) are provided in the first doped layers (111), doped contact portions (111b) with polarity different from that of the first doped layers (111) are formed in the concave portions (111a), and the first doped layers (111) are in contact with the doped contact portions (111b).

2. The solar cell according to claim 1, wherein
an orthogonal projection of one of the concave portions (111a) on the first surface (11a) has a circular shape, a polygonal shape, or an irregular shape.

3. The solar cell according to claim 1, wherein
a spacing region (113) is provided between the first doped layer (111) and the second doped layer (112) adjacent to each other; and
a minimum distance between the doped contact portion (111b) and the second doped layer (112) is a width of the spacing region (113).

4. The solar cell according to claim 1, wherein an area ratio of the concave portions (111a) to the first doped layers (111) is a, where 0.05 %≤a≤5 %.

5. The solar cell according to claim 4, wherein the area ratio of the concave portions (111a) to the first doped layers (111) is satisfies: 0.3 N≤a≤1.5 %.

6. The solar cell according to claim 1, wherein a one-dimensional size of one of the concave portions (111a) is b, where 0.5µm≤b≤240µm.

7. The solar cell according to claim 1, wherein
the solar cell (1) further comprises a first electrode (114) stacked to and electrically connected to the first doped layers (111); and
along a thickness direction (Z) of the solar cell (1), a projection of each of the doped contact portions (111b) on the first surface (11a) is not coincident with a projection of the first electrode (114) on the first surface (11a).

8. The solar cell according to claim 7, wherein
along the thickness direction (Z) of the solar cell (1), the projection of each of the doped contact portions (111b) on the first surface (11a) does not overlap with the projection of the first electrode (114) on the first surface (11a).

9. The solar cell according to claim 1, wherein the doped contact portions (111b) are uniformly distributed in the first doped layers (111).

10. The solar cell according to claim 1, wherein the doped contact portions (111b) are non-uniformly distributed in the first doped layers (111).

11. The solar cell according to any one of claims 1 to 6, wherein in a direction perpendicular to the thickness direction (Z) of the solar cell (1), the doped contact portions (111b) cover at least part of side walls of the concave portions (111a).

12. The solar cell according to claim 11, wherein the doped contact portions (111b) does not cover bottom walls of the concave portions (111a).

13. The solar cell according to claim 11, wherein the doped contact portions (111b) cover at least part of bottom walls of the concave portions (111a).

14. The solar cell according to claim 11, wherein the concave portions (111a) do not penetrate through the first doped layers (111), and the doped contact portions (111b) cover bottom walls of the concave portions (111a).

15. The solar cell according to claim 11, wherein
the concave portions (111a) penetrate through the first doped layers (111), and part of the silicon substrate (11) is exposed from the concave portions (111a); and
the doped contact portions (111b) cover the part of the silicon substrate (11) exposed from the concave portions (111a).
